# FASCICULE DE BREVET EUROPEEN

(11) **EP 0 630 061 B1**
(45) Date de publication et mention de la délivrance du brevet: **25.09.1996**
(21) Numéro de dépôt: 94401297.0
(22) Date de dépôt: 09.06.1994
(51) Int. Cl.: H01L 39/24

(54) **Procédé de fabrication d'un fil gainé en supraconducteur à haute température critique**
Verfahren zum Herstellen eines supraleitenden umkleideten Hochtemperaturdrahts
Method of making a sheathed high temperature superconducting wire

(30) Priorité: 10.06.1993 FR 9306993
(43) Date de publication de la demande: 21.12.1994
(73) Titulaire: ALCATEL ALSTHOM COMPAGNIE GENERALE D'ELECTRICITE, F-75008 Paris (FR)
(72) Inventeur: Duperray, Gérard, F-91290 La Norville (FR); Legat, Denis, F-91090 Lisses (FR)
(74) Mandataire: Laroche, Danièle

(56) Documents cités:
- EP-A- 0 404 966
- EP-A- 0 457 929
- EP-A- 0 559 574
- WO-A-89/06053

## Description

La présente invention concerne un procédé de fabrication d'un fil gainé en supraconducteur à haute température critique, et en particulier le procédé dit "poudre dans tube" décrit notamment dans le brevet français FR-A-2 675 620.

Très schématiquement rappelons que, dans la première phase d'un tel procédé, appelée Etage 0, on introduit dans un tube en argent de la poudre supraconductrice et on ferme ce tube sous vide. Ensuite on effectue les opérations suivantes:
- on étire le tube dans une filière et l'on obtient un monobrin,
- on réalise une billette en garnissant un second tube en argent de tronçons du monobrin et on ferme sous vide le second tube,
- on étire et/ou on lamine jusqu'à la dimension souhaitée pour le fil.
- on effectue un traitement thermique final.

Après l'adoption d'un tel procédé les expérimentateurs ont constaté rapidement qu'une augmentation du facteur de forme de l'âme supraconductrice du fil apportait un gain appréciable de courant critique de transport. Cette géométrie, obtenue par pressage ou laminage, augmente notablement l'interface entre l'argent du tube et le matériau supraconducteur, suggérant un rôle bénéfique de cet interface dans le processus de texturation des composés supraconducteurs lamellaires.

Quand les équipes ont cherché à réaliser des brins multifilamentaires en vue d'applications industrielles en courant alternatif, elles se sont efforcées de conserver un facteur de forme élevé dans ces nouvelles structures. Trois variantes ont vu le jour:
Variante a): Etage 0 rond avec monofilaments ronds ou hexagonaux.
Variante b): Etage 0 rond avec monofilaments rectangulaires.
Variante c): Etage 0 rectangulaire avec monofilaments rectangulaires.

La variante a) est décrite dans la demande de brevet Européen EP-A-504 895 et dans l'article paru dans J.App. Phys 1991 70(3) p.1596-99.
Elle comprend les étapes suivantes:
- Remplissage d'un tube d'argent avec de la poudre supraconductrice.
- Fermeture du tube sous vide.
- Etirage en filière sous forme de brin rond ou hexagonal.
- Réalisation d'une billette en garnissant un deuxième tube d'argent.
- Etirage identique à l'étirage précédent.
- Ecrasement du multibrin par laminage.

Lors de cette dernière étape, le multibrin prend la forme d'un ruban et les filaments supraconducteurs acquièrent une section en ellipse très aplatie; mais la géométrie globale est alors très désordonnée; il se produit des croisements de filaments pouvant engendrer des ruptures de continuité.

La Variante b) est décrite dans le brevet US-A-5 114 908 et dans l'article paru dans " Cryogenics" 1992 52(11) p. 940-947.

Les cinq premières étapes sont identiques à celles de la Variante a), puis le brin monofilamentaire rond est alors soit laminé, soit étiré en filière rectangulaire. La fabrication se poursuit de la manière suivante:
- Réalisation d'une billette par disposition en couronne des brins à section rectangulaire autour d'une âme cylindrique en argent, introduction dans un tube et fermeture sous vide.
- Etirage en filière circulaire.

Avec un tel procédé, le rapport de la section utile du fil à la section totale est inférieure à 10% à cause de la grande part prise par l'âme d'argent.

La Variante c) est décrite dans le brevet français FR-A-2 675 620.

L'Etage 0 de cette variante est distinct de celui des variantes a) et b) puisqu'il est rectangulaire.

La billette est réalisée par empilage des monobrins rectangulaires dans un tube à section carrée; après fermeture sous vide, cette billette est étirée dans une filière à galets jusqu'à obtention d'un ruban d'épaisseur inférieure à 2 mm, lui-même laminé jusqu'à 0,5 et même 0,3 mm. A l'état final, les filaments ont une épaisseur inférieure à 20 microns et un facteur de forme supérieure à 60.

Dans les trois Variantes a) b) c) le matériau supraconducteur est généralement introduit sous forme de poudre dans le tube d'argent. Mais il a été décrit dans l'article paru dans "App.Superconductivity" 1993-1- (10-12) p.1515-22 que l'on pouvait introduire dans le tube un barreau cylindrique obtenu par agglomération de la poudre par compression isostatique.

On a constaté que l'obtention par les procédés connus de structures de fil à grand facteur de forme posait des problèmes spécifiques.

On observe tout d'abord une difficulté du maintien de l'homothétie au cours des opérations d'étirage.

D'une part l'aptitude au fluage de la céramique dépend de sa granulométrie (grain élémentaire et taille des agglomérats) et de son état de cristallisation (morphologie des grains). Ces paramètres évoluent, en plus, au cours de la transformation.

D'autre part, l'argent après recuit est beaucoup plus ductile que la poudre agglomérée, mais il s'écrouit peu à peu, d'où des problèmes de déformation dûs aux différences de fluage des deux matériaux à un moment donné. Ainsi une granulométrie fine (< 30 microns) provoque le phénomène de striction aboutissant à des casses répétées.

Pour atténuer ces défauts, il convient d'appliquer des facteurs de réduction faibles, inférieurs à 10% en section entre deux passes, et il est nécessaire d'effectuer des recuits fréquents, chaque fois que la section est réduite de 40%.
Malheureusement ces recuits de l'argent entraînent une évolution du rapport de la section supraconductrice à la section totale, due au fluage différentiel de l'argent et du supraconducteur; l'argent est repoussé aux extrémités du fil. Il est donc nécessaire de tenir compte de ce phénomène dans le choix initial du rapport de forme (par exemple 40% au départ pour obtenir 30% sur le fil terminé). Un tel choix est difficile sachant que l'évolution au cours du procédé est variable selon le type de poudre et la gamme de fabrication.

Les difficultés qui viennent d'être exposées compliquent la fabrication et entraînent un surcoût, mais ne compromettent pas la qualité du produit final. Il n'en est pas de même de la présence de gros grains durs dans la poudre, généralement des phases parasites de la phase supraconductrice, qui déforment la gaine d'argent, créent des ampoules dans les filaments et arrivent même à perforer la couronne extérieure d'argent, entraînant des fuites de composés liquides ou volatils lors des traitements thermiques.

La présente invention a pour but d'améliorer le procédé "poudre dans tube" de manière, d'une part à s'affranchir des problèmes posés par les phases parasites du matériau supraconducteur, et d'autre part à améliorer le comportement du fil pendant toutes les phases d'étirage.

La présente invention a pour objet un procédé de fabrication d'un fil gainé en supraconducteur à haute température critique, procédé dit "poudre dans tube" selon lequel on effectue les opérations suivantes:
- on remplit un premier tube d'argent avec un barreau de poudre supraconductrice à haute température critique comprimée, et on ferme ce premier tube sous vide,
- on étire ledit tube dans une filière et l'on obtient un monobrin,
- on réalise une billette en garnissant un second tube en argent de tronçons dudit monobrin et on ferme sous vide ledit second tube,
- on étire et/ou on lamine jusqu'à la dimension souhaitée pour ledit fil,
- on effectue un traitement thermique final,
procédé caractérisé par le fait que, préalablement à son introduction dans ledit premier tube d'argent, ledit barreau de poudre comprimée est traité thermiquement avec les étapes suivantes:
- un palier à température élevée T₁ sous une atmosphère oxygénée destiné à recristalliser la phase supraconductrice de ladite poudre en présence de traces de phases liquides et à épuiser au maximum les phases résiduelles,
- une descente lente, de 1 à 5°C par heure jusqu'à une température T₂ pour éviter la précipitation aux joints de grains de microcristaux desdites phases résiduelles,
- une descente rapide jusqu'à une température T₃,
- un palier à ladite température T₃ pendant lequel on augmente la concentration des porteurs dudit matériau supraconducteur.

Si ladite poudre est du type
(Bi, Pb)₂ Sr₂₋ₓ Ca₂ Cu_{3-y} O_{z},
- T₁ est comprise entre 790°C et 840°C, pendant un temps compris entre 45 et 100 heures.
- T₂ est choisie égale à T₁-20°C et la vitesse de la descente entre T₁ et T₂ est comprise entre 2°C et 5°C par heure,
- T₃ est comprise entre 400°C et 600°C et la vitesse de descente entre T₂ et T₃ est comprise entre 120°C et 300°C par heure.
- La durée du palier à T₃ est comprise entre 10 et 20 heures sous oxygène pur.

La durée de palier à la température T₁ dépend du degré de synthèse de la poudre employée. Elle sera de 45 à 60 heures pour un produit pur à 90% et de l'ordre de 100 heures pour un produit commercial dont la teneur en phase supraconductrice est généralement inférieure à 80%.

Dans le cas où ladite poudre est stoechiométrique, c'est-à-dire de formule (Bi, Pb)₂ Sr₂ Ca₂ Cu₃ O₁₀,
- T₁ est choisie égale à 815°C pendant 60 heures,
- T₂ est choisie égale à 795°C avec une vitesse de descente entre T₁ et T₂ égale à 3°C par heure,
- T₃ est égale à 450°C avec une vitesse de descente entre T₁ et T₂ égale à 450°C,
- La durée du palier à T₃ est de 20 heures sous oxygène pur.

Dans le cas où ladite poudre est du type Bi₂ Sr₂ Ca Cu₂ O₈ , le procédé comprend une étape supplémentaire selon laquelle, préalablement au palier à la température T₁, on prévoit une montée en température au moins égale à 870°C pour provoquer la fusion complète de ladite poudre; en outre
- T₁ est comprise entre 830°C et 870°C, pendant un temps compris entre 20 et 50 heures,
- T₂ est choisie égale à T₁-20°C et la vitesse de descente entre T₁ et T₂ est comprise entre 2°C et 5°C par heure,
- T₃ est comprise entre 600°C et 700°C, et la vitesse de descente entre T₂ et T₃ est comprise entre 120°C et 300°C par heure,
- La durée du palier à T₃ est comprise entre 20 et 40 heures sous azote pur.

Enfin dans le cas où ladite poudre est du type YBa₂ Cu₃ O_{7-z},
- T₁ est comprise entre 930°C et 960°C, pendant un temps compris entre 0,5 et 5 heures,
- T₂ est choisie égale à T₁-30°C et la vitesse de descente entre T₁ et T₂ est comprise entre 1°C et 3°C par heure,
- T₃ est comprise entre 400 et 500°C, et la vitesse de descente entre T₂ et T₃ est comprise entre 120°C et 300°C par heure,
- La durée du palier à T₃ est comprise entre 10 et 20 heures.

On constate que, dans toutes les variantes de mise en oeuvre, la caractéristique de l'invention permet de manière tout à fait inattendue de fractionner les grains parasites de ladite poudre en grains plus petits, et même de les résorber complètement.

En outre elle permet la nette amélioration du comportement du fil pendant l'étirage, ce qui entraîne une nette réduction du nombre des recuits de détente : un seul recuit est nécessaire alors qu'il en fallait dix auparavant.

Il semble que la céramique, ayant recristallisé sous forme de feuillets, atteigne un comportement au fluage en accord avec la ductilité de l'argent. Les écoulements sont plus réguliers et les efforts plus faibles; il n'y a plus de "bourrages" ni d'amorces de strictions; l'argent s'écrouit moins et le fluage des deux matériaux s'effectue harmonieusement, maintenant constant le rapport de la section supraconductrice à la section totale, tout au long des opérations mécaniques.

D'autres caractéristiques et avantages de la présente invention apparaîtront au cours de la description suivante de modes de réalisation donnés à titre illustratif mais nullement limitatif. Dans le dessin annexé:
- La figure 1 montre une coupe d'un monobrin obtenu à l'aide d'un procédé de l'art antérieur.
- La figure 2 montre une coupe d'un brin multifilamentaire de l'art antérieur obtenu à partir du monobrin de la figure 1.
- La figure 3 montre une coupe du brin multifilamentaire de la figure 2 à l'échelle agrandie, après le traitement thermique final.
- La figure 4 montre une coupe d'un monobrin obtenu à l'aide du procédé selon l'invention.
- La figure 5 montre une coupe d'un fil selon l'invention.

### Exemple 1 - Art antérieur

On réalise des cylindres de diamètre 10 mm par compression isostatique de poudre de Bi2223 :
(Bi, Pb)₂ Sr₂ Ca₂ Cu₃ O₁₀).

Ces cylindres sont introduits dans un tube d'argent de diamètre intérieur 10 mm, et de diamètre extérieur 12 mm; ce tube est fermé sous vide.

Cette billette est étirée en filière circulaire jusqu'au diamètre 5 mm, puis en filière à galets jusqu'à l'obtention d'un ruban de section 3x0,75 mm² en appliquant, dans les deux cas à chaque passe un coefficient de réduction de 10% en section (5% en diamètre).

On effectue un recuit de détente de la gaine d'argent pendant 24 heures à 350°C, chaque fois qu'on a réduit la section de 40%.

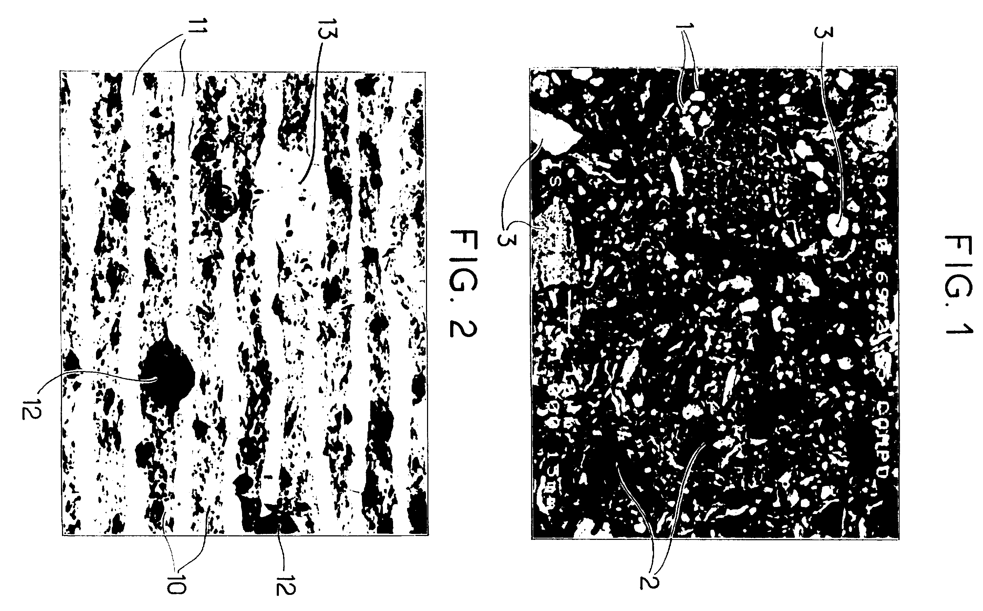

La figure 1 montre une coupe de monobrin obtenu. La structure est hétérogène. Les grains 1 de phase Bi2223 qui apparaissent gris sont arrondis et ceux de phases parasites 3,2 qui apparaissent blancs et noirs sont gros et mal répartis.

Le monobrin est découpé en tronçons qui sont insérés, en paquets de quinze tronçons, dans un tube à section carrée de côté intérieur 10 mm, et de côté extérieur 12 mm; ce tube est fermé sous vide.
La billette ainsi constituée est étirée dans une filière à galets. Le ruban est amené à sa cote finale de 3x0,5 mm² et traité thermiquement 60 heures à 815°C en atmosphère oxygénée.

Le brin définitif présente une géométrie régulière constituée de filaments d'épaisseur 15 à 20 microns, ayant un facteur de forme supérieur à 60, mais on note une dégradation de la géométrie par des nodules durs de phases parasites du matériau supraconducteur ayant déformé les parois d'argent. Ainsi on voit dans la figure 2 en coupe les filaments 10 et leur gaine d'argent 11, et des nodules durs référencés 12 (Ca₂ CuO₃) et 13 (Ca₂ PbO₄).

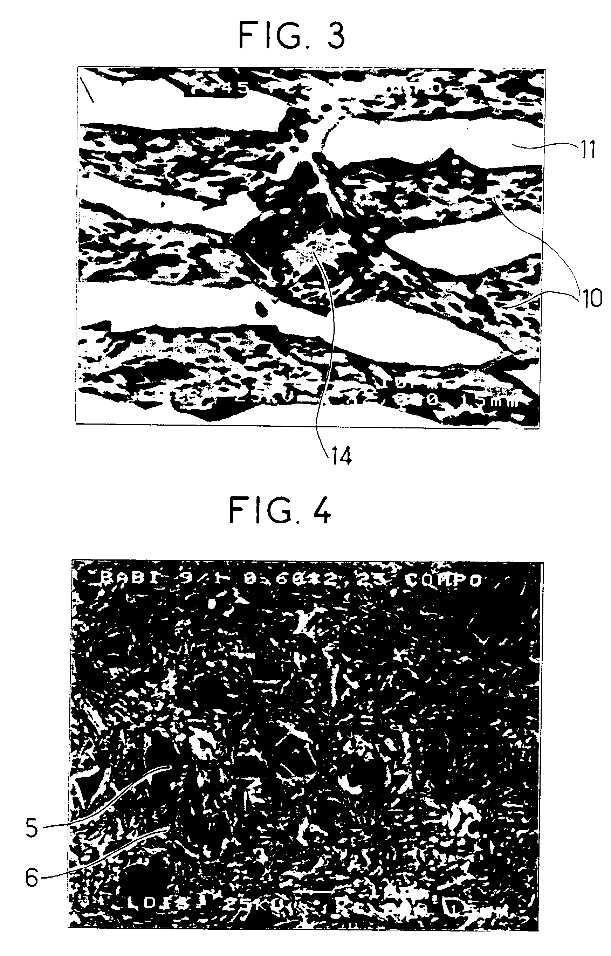

Dans la figure 3, on voit l'emplacement 14 d'un ancien nodule 12 ou 13 qui a été retransformé en phase supraconductrice Bi2223 lors de l'ultime traitement thermique que l'on fait subir au fil; une cavité demeure à l'emplacement 14 de l'ancien nodule 12 ou 13.

### Exemple 2

On réalise des cylindres de diamètre 10 mm par compression isostatique de poudre de Bi2223 stoechiométrique comme dans l'exemple 1.

Selon l'invention ces cylindres sont traités thermiquement 60 heures à T₁ = 815°C. On descend ensuite leur température à raison de 3°C par heure jusqu'à T₂ = 795°C, puis à raison de 200°C par heure jusqu'à T₃ = 450°C. La durée du palier à T₃ est de 20 heures sous oxygène pur.

Après ce traitement thermique, les barreaux ne prennent pas de retrait. Ils sont alors introduits dans un tube d'argent de diamètre intérieur 10 mm et de diamètre extérieur 12 mm; ce tube est fermé sous vide.

Cette billette est étirée en filière circulaire jusqu'au diamètre 5 mm, puis en filière à galets jusqu'à obtention d'un ruban de section 2,4x0,75 mm² en appliquant, dans les deux cas à chaque passe un coefficient de réduction de 15% en section (8% en diamètre). On n'effectue qu'un seul recuit de détente de la gaine d'argent pendant 24 heures à 350°C.

Le monobrin obtenu est visible en coupe dans la figure 4. Si on compare à la coupe de la figure 1, on voit que les grains de phases parasites 5 sont plus petits ou clivés et qu'ils sont mieux répartis dans une structure 6 homogène de phase Bi2223 recristallisée en feuillets.

Le monobrin est découpé en tronçons qui sont insérés, en quatre paquets de treize tronçons, dans un tube à section carrée de côté intérieur 10 mm et de côté extérieur 12 mm; ce tube est fermé sous vide.

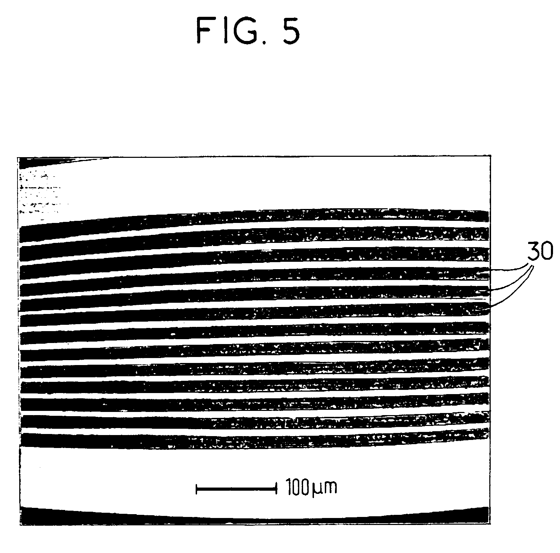

La billette ainsi constituée est étirée en filière à galets et le ruban est amené à sa cote finale de 3x0,5 mm² et retraité thermiquement comme dans l'exemple 1. Le brin multifilamentaire ainsi obtenu est visible en coupe dans la figure 5; il présente une géométrie régulière et sans défauts constituée de filaments 30 d'épaisseur 15 à 20 microns, ayant un facteur de forme supérieur à 60.

### Exemple 3 :

Il est identique à l'exemple 2 selon l'invention, sauf en ce qui concerne la poudre employée qui est une poudre non stoechiométrique de formule (Bi, Pb)₂ Sr_{1,6} Ca₂ Cu_{2,8} O_{9,2}.

Les paramètres du traitement thermique du barreau de poudre initial sont les suivants:
T₁ = 800°C pendant 100 heures.
T₂ = 700°C avec une vitesse de descente entre T₁ et T₂ égale à 3°C par heure.
T₃ = 450°C avec une descente entre T₂ et T₃ égale à 200°C par heure.
Palier à T₃ sous oxygène pur pendant 20 heures.

Les améliorations au niveau de la facilité de fabrication du brin multifilamentaire et de la qualité de la géométrie sont identiques à celles obtenues avec l'exemple 2.

### Exemple 4 :

Il est identique à l'exemple 2 selon l'invention sauf en ce qui concerne la poudre employée qui a pour formule Bi₂ Sr₂ Ca Cu₂ O₈ et une montée initiale en température égale à 870°C. Les autres étapes se succèdent ainsi:
T₁ = 850°C pendant 50 heures.
T₂ = 820°C avec une vitesse de descente entre T₁ et T₂ égale à 3°C par heure.
T₃ = 650°C avec une vitesse de descente entre T₂ et T₃ égale à 200°C par heure.
Palier à T₃ sous azote pur pendant 40 heures.

On observe les mêmes améliorations qu'avec les exemples 2 et 3.

### Exemple 5 :

On réalise, par compression isostatique de poudre de YBa₂ Cu₃ O₇ des cylindres de diamètre 7 mm.

Ces cylindres sont traités thermiquement selon l'invention:
1 heure à T₁ = 940°C en atmosphère oxygénée.
La température descend jusqu'à T₂ = 910°C à raison de 2°C/heure, puis jusqu'à T₃ = 450°C à raison de 120°C/heure.
La durée du palier à T₃ est de 20 heures sous oxygène pur.

Les barreaux ayant pris du retrait, leur diamètre est passé à 6 mm. Ils sont alors introduits dans un tube d'argent de diamètre intérieur 6 mm et de diamètre extérieur 8 mm; ce tube est fermé sous vide.

Cette billette est étirée en filière circulaire jusqu'au diamètre 3 mm, puis en filière à galets jusqu'à obtention d'un ruban de section 2,4x0,75 mm² en appliquant, dans les deux cas à chaque opération un coefficient de réduction de 10% en section (5% en diamètre). On n'effectue qu'un seul recuit de détente de la gaine d'argent, pendant 24 heures à 350°C, avant de commencer l'étirage en filière à galets.

Le fil ainsi obtenu est découpé en tronçons qui sont insérés, en quatre paquets de treize tronçons, dans un tube à section carrée de côté intérieur 10 mm et de côté extérieur 12 mm; ce tube est fermé sous vide.

La billette ainsi constituée est étirée en filière à galets jusqu'à sa cote finale de 3x0,5 mm² et retraitée thermiquement.

Le brin définitif présente une géométrie régulière constituée de filaments d'épaisseur 15 à 20 microns, ayant un facteur de forme supérieur à 60.

Bien entendu l'invention n'est pas limitée aux exemples de matériaux supraconducteurs mentionnés ci-dessus. Dans tous les cas, le procédé selon l'invention apporte d'importants progrès au niveau de la reproductibilité, de la simplicité de mise en oeuvre et du coût.

## Revendications

1. Procédé de fabrication d'un fil gainé en supraconducteur à haute température critique, procédé dit "poudre dans tube" selon lequel on effectue les opérations suivantes:
- on remplit un premier tube d'argent avec un barreau de poudre supraconductrice à haute température critique comprimée et on ferme ce premier tube sous vide,
- on étire ledit tube dans une filière et l'on obtient un monobrin,
- on réalise une billette en garnissant un second tube en argent de tronçons dudit monobrin et on ferme sous vide ledit second tube,
- on étire et/ou on lamine jusqu'à la dimension souhaitée pour ledit fil,
- on effectue un traitement thermique final,
procédé caractérisé par le fait que, préalablement à son introduction dans ledit premier tube d'argent, ledit barreau de poudre comprimée est traité thermiquement avec les étapes suivantes:
- un palier à température élevée T₁ sous une atmosphère oxygénée destiné à recristalliser la phase supraconductrice de ladite poudre en présence de traces de phases liquides et à épuiser au maximum les phases résiduelles,
- une descente lente, de 1 à 5°C par heure jusqu'à une température T₂ pour éviter la précipitation aux joints de grains de microcristaux desdites phases résiduelles,
- une descente rapide jusqu'à une température T₃,
- un palier à ladite température T₃ pendant lequel on augmente la concentration des porteurs dudit matériau supraconducteur.

2. Procédé selon la revendication 1, caractérisé par le fait que, ladite poudre étant de formule
(Bi Pb)₂ Sr₂₋ₓ Ca₂ Cu_{3-y} O_{z},
- T₁ est comprise entre 790°C et 840°C, pendant un temps compris entre 45 et 100 heures,
- T₂ est choisie égale à T₁-20°C et la vitesse de la descente entre T₁ et T₂ est comprise entre 2°C et 5°C par heure,
- T₃ est comprise entre 400°C et 600°C et la vitesse de descente entre T₂ et T₃ est comprise entre 120°C et 300°C par heure,
- La durée du palier à T₃ est comprise entre 10 et 20 heures sous oxygène pur.

3. Procédé selon la revendication 2, caractérisé par le fait que ladite poudre étant stoechiométrique de formule Bi₂ Sr₂ Ca₂ Cu₃ O₁₀,
- T₁ est choisie égale à 815°C pendant 60 heures,
- T₂ est choisie égale à 795°C avec une vitesse de descente entre T₁ et T₂ égale à 3°C par heure,
- T₃ est égale à 450°C avec une vitesse de descente entre T₁ et T₂ égale à 200°C par heure,
- La durée du palier à T₃ est de 20 heures sous oxygène pur.

4. Procédé selon la revendication 1, caractérisé par le fait que ladite poudre étant de formule Bi₂ Sr₂ Ca Cu₂ O₈,
caractérisé par le fait que, préalablement au palier à la température T₁ , on prévoit une montée en température au moins égale à 870°C pour provoquer la fusion complète de ladite poudre
et par le fait que :
- T₁ est comprise entre 830°C et 870°C, pendant un temps compris entre 20 et 50 heures,
- T₂ est choisie égale à T₁-20°C et la vitesse de descente entre T₁ et T₂ est comprise entre 2°C et 5°C par heure,
- T₃ est comprise entre 600°C et 700°C, et la vitesse de descente entre T₂ et T₃ est comprise entre 120°C et 300°C par heure,
- La durée du palier à T₃ est comprise entre 20 et 40 heures sous azote pur.

5. Procédé selon la revendication 1, caractérisé par le fait que ladite poudre étant du type YBa₂ Cu₃ O_{7-z},
- T₁ est comprise entre 930°C et 960°C, pendant un temps compris entre 0,5 et 5 heures,
- T₂ est choisie égale à T₁-30°C et la vitesse de descente entre T₁ et T₂ est comprise entre 1°C et 3°C par heure,
- T₃ est comprise entre 400 et 500°C, et la vitesse de descente entre T₂ et T₃ est comprise entre 120°C et 300°C par heure,
- La durée du palier à T₃ est comprise entre 10 et 20 heures.

## Patentansprüche

1. Verfahren zur Herstellung eines umhüllten supraleitenden Drahts mit hoher kritischer Temperatur, d.h. ein sogenanntes "Pulver-im-Rohr"-Verfahren, gemäß dem man die folgenden Verfahrensschritte ausführt:
- man füllt ein erstes Silberrohr mit einem Stab aus einem supraleitenden komprimierten Pulver mit hoher kritischer Temperatur und man schließt dieses erste Rohr unter Vakuum;
- man streckt das Rohr in einem Zieheisen und erhält eine Einzelader,
- man stellt einen Barren her, indem man ein zweites Silberrohr mit Abschnitten der Einzelader versieht, und man schließt dieses zweite Rohr unter Vakuum,
- man streckt und/oder walzt diesen Draht bis zur gewünschten Abmessung,
- man führt eine End-Wärmebehandlung durch,
dadurch gekennzeichnet, daß vor der Einführung in das erste Silberrohr der Stab aus komprimiertem Pulver gemäß folgenden Schritten wärmebehandelt wird:
- eine Stufe bei hoher Temperatur T₁ unter sauerstoffhaltiger Atmosphäre, die dazu bestimmt ist, die supraleitende Phase des Pulvers in Gegenwart von Spuren von flüssigen Phasen wieder zu kristallisieren und die verbleibenden Phasen in größtmöglichem Maß zu erschöpfen,
- ein langsames Absinken mit 1 bis 5°C pro Stunde bis auf eine Temperatur T₂, um die Ausfällung von Mikrokristallen der Restphasen an den Korngrenzen zu vermeiden,
- ein schnelles Absinken bis auf eine Temperatur T₃,
- eine Stufe bei dieser Temperatur T₃, während der man die Konzentration an Trägern des supraleitenden Materials erhöht.

2. Verfahren nach Anspruch 1, dadurch gekennzeichnet, daß, wenn das Pulver von der Art (Bi, Pb)₂Sr₂₋ₓCa₂Cu_{3-y}O_{z} ist,
- T₁ zwischen 790°C und 840°C liegt und während einer Zeit zwischen 45 und 100 Stunden angewendet wird,
- T₂ gleich T₁-20°C gewählt wird und die Sinktemperatur zwischen T₁ und T₂ zwischen 2°C und 5°C pro Stunde liegt,
- T₃ zwischen 400°C und 600°C gewählt wird und die Sinkgeschwindigkeit zwischen T₂ und T₃ zwischen 120°C und 300°C pro Stunde liegt,
- die Dauer der Stufe bei T₃ zwischen 10 und 20 Stunden in reinem Sauerstoff liegt.

3. Verfahren nach Anspruch 2, dadurch gekennzeichnet, daß, wenn das Pulver stöchiometrisch gemäß der Formel Bi₂Sr₂Ca₂Cu₃O₁₀ ist,
- T₁ gleich 815°C gewählt und während 60 Stunden angewendet wird,
- T₂ gleich 795°C gewählt wird und die Sinkgeschwindigkeit zwischen T₁ und T₂ bei 3°C pro Stunde liegt,
- T₃ gleich 450°C gewählt wird und die Sinkgeschwindigkeit zwischen T₂ und T₃ 200°C beträgt,
- die Dauer der Stufe auf der Temperatur T₃ 20 Stunden in reinem Sauerstoff beträgt.

4. Verfahren nach Anspruch 1, dadurch gekennzeichnet, daß, wenn das Pulver aus Bi₂Sr₂CaCu₂O₈ ist, vor der Stufe bei der Temperatur T₁ ein Temperaturanstieg auf mindestens gleich 870°C vorgesehen ist, um das vollständige Schmelzen des Pulvers zu bewirken, und daß
- T₁ zwischen 830°c und 870°C liegt und während einer Zeit von zwischen 20 und 50 Stunden angewendet wird,
- T₂ gleich T₁-20°C gewählt wird und die Sinkgeschwindigkeit zwischen T₁ und T₂ zwischen 2°C und 5°C pro Stunde liegt,
- T₃ zwischen 600°C und 700°C liegt und die Sinkgeschwindigkeit von zwischen T₂ nach T₃ zwischen 120°C und 300°C pro Stunde liegt,
- die Dauer der Stufe auf der Temperatur T₃ zwischen 20 und 40 Stunden in reinem Stickstoff liegt.

5. Verfahren nach Anspruch 1, dadurch gekennzeichnet, daß, wenn das Pulver aus YBa₂Cu₃O_{7-z} ist,
- T₁ zwischen 930°c und 960°C gewählt wird und während einer Zeit zwischen 0,5 und 5 Stunden angewendet wird,
- T₂ gleich T₁-30°C gewählt wird und die Sinkgeschwindigkeit zwischen T₁ und T₂ zwischen 1°C und 3°C pro Stunde liegt,
- T₃ zwischen 400°C und 500°C gewählt wird und die Sinkgeschwindigkeit von T₂ nach T₃ zwischen 120°C und 300°C pro Stunde liegt,
- die Dauer der Stufe auf der Temperatur T₃ zwischen 10 und 20 Stunden liegt.

## Claims

1. Method for the manufacture of an encased high critical temperature superconducting wire, a "powder in tube" method, comprising the following operations:
. filling a first silver tube with a rod of compressed high critical temperature superconducting powder and sealing the first tube under vacuum;
. drawing said tube through a wire-draw die to produce a single strand;
. forming a billet by providing a second silver tube with sections of said single strand and sealing said second tube under vacuum;
. drawing and/or rolling the billet to the dimensions desired for said wire; and
. carrying out final heat treatment;
the method being characterized in that, prior to being introduced into said first silver tube, said rod of compressed powder is heat treated in the following stages:
. a period at a high temperature T₁ in an oxygen atmosphere to recrystallize the superconducting phase of said powder in the presence of traces of liquids and to eliminate the unwanted phases as much as possible;
. a slow descent at 1°C to 5°C per hour to a temperature T₂ to avoid precipitating microcrystals of said unwanted phases at the grain boundaries;
. a rapid descent to a temperature T₃; and
. a period at said temperature T₃ during which the concentration of carriers in said superconducting material is increased.

2. Method according to claim 1, characterized in that said powder has formula:
(Bi,Pb)₂Sr₂₋ₓCa₂Cu_{3-y}O_{z}
. T₁ lies in the range 790°C to 840°C, for a period that lies in the range 45 hours to 100 hours;
. T₂ is equal to T₁ - 20°C and the rate of descent from T₁ to T₂ lies in the range 2°C to 5°C per hour;
. T₃ lies in the range 400°C to 600°C and the rate of descent from T₂ to T₃ lies in the range 120°C to 300°C per hour; and
. the duration of the period at T₃ lies in the range 10 hours to 20 hours under pure oxygen.

3. Method according to claim 2, characterized in that said powder is stoichiometric with formula:
Bi₂Sr₂Ca₂Cu₃O₁₀
. T₁ is 815°C, for 60 hours;
. T₂ is 795°C and the rate of descent from T₁ to T₂ is 3°C per hour;
. T₃ is 450°C and the rate of descent from T₂ to T₃ equals 200°C per hour; and
. the duration of the period at T₃ is 20 hours in pure oxygen.

4. Method according to claim 1, characterized in that said powder has formula:
Bi₂Sr₂CaCu₂O₈
characterized in that, prior to the period at temperature T₁, the temperature is raised to at least 870°C to fuse said powder completely; and in that
. T₁ lies in the range 830°C to 870°C, for a period lying in the range 20 hours to 50 hours;
. T₂ is equal to T₁ - 20°C and the rate of descent from T₁ to T₂ lies in the range 2°C to 5°C per hour;
. T₃ lies in the range 600°C to 700°C and the rate of descent from T₂ to T₃ lies in the range 120°C to 300°C per hour; and
. the duration of the period at T₃ lies in the range 20 hours to 40 hours in pure nitrogen.

5. Method according to claim 1, characterized in that said powder is of the type:
YBa₂Cu₃O_{7-z}
. T₁ lies in the range 930°C to 960°C, for a period lying in the range 0.5 hours to 5 hours;
. T₂ is equal to T₁ - 30°C and the rate of descent from T₁ to T₂ lies in the range 1°C to 3°C per hour;
. T₃ lies in the range 400°C to 500°C and the rate of descent from T₂ to T₃ lies in the range 120°C to 300°C per hour; and
. the duration of the period at T₃ lies in the range 10 hours to 20 hours.
